# EUROPÄISCHE PATENTSCHRIFT

(11) **EP 3 894 348 B1**
(45) Veröffentlichungstag und Bekanntmachung des Hinweises auf die Patenterteilung: **17.08.2022**
(21) Anmeldenummer: 19809110.0
(22) Anmeldetag: 02.12.2019
(51) Int. Cl.: B66B 19/00

(54) **VERFAHREN ZUR ZUMINDEST TEILWEISE AUTOMATISIERTEN PLANUNG EINER INSTALLATION VON AUFZUGKOMPONENTEN EINER AUFZUGANLAGE**
METHOD FOR AT LEAST PARTIALLY AUTOMATED PLANNING OF AN INSTALLATION OF ELEVATOR COMPONENTS OF AN ELEVATOR ASSEMBLY
PROCÉDÉ DE PLANIFICATION AU MOINS PARTIELLEMENT AUTOMATIQUE D'UNE INSTALLATION DES COMPOSANTS D'ASCENSEUR D'UNE INSTALLATION D'ASCENSEUR

(30) Priorität: 13.12.2018 EP 18212328
(43) Veröffentlichungstag der Anmeldung: 20.10.2021
(73) Patentinhaber: Inventio AG, 6052 Hergiswil (CH)
(72) Erfinder: BÜTLER, Erich, 6030 Ebikon (CH); ZIMMERLI, Philipp, 4624 Härkingen (CH); BITZI, Raphael, 6003 Luzern (CH)
(74) Vertreter: Inventio AG
(86) Internationale Anmeldenummer: PCT/EP2019/083250
(87) Internationale Veröffentlichungsnummer: WO 2020/120190

(56) Entgegenhaltungen:
- EP-A1- 3 085 658
- WO-A1-2017/016783
- WO-A1-2018/041815
- JP-A- 2018 054 346

## Beschreibung

Die Erfindung betrifft ein Verfahren zur zumindest teilweise automatisierten Planung einer Installation von Aufzugkomponenten einer Aufzuganlage gemäss dem Oberbegriff des Anspruchs 1.

Die EP 3085658 B1 beschreibt ein Verfahren zur teilweise automatisierten Planung und Durchführung einer Installation von Aufzugkomponenten einer Aufzuganlage in einem von Schachtwänden begrenzten Aufzugschacht. Bei diesem Verfahren werden Türöffnungen des Aufzugschachts mittels Reflektoren markiert. Anschliessend wird mittels einer im Aufzugschacht angeordneten automatisierten Scan-Vorrichtung in Form einer so genannten Total Station Verläufe der Schachtwände sowie die Positionen der Reflektoren und damit der Türöffnungen erfasst. Basierend auf den Positionen der Türöffnungen und Abmassen einer Aufzugkabine der Aufzuganlage werden anschliessend Soll-Verläufe von mindestens zwei aus einzelnen Führungsschienenstücken zusammengesetzten Führungsschienen zum Führen der Aufzugkabine innerhalb des Aufzugschachts festgelegt. Das unterste Führungsschienenstück jeder Führungsschiene wird von einem Monteur von Hand an einer Schachtwand fixiert. Anschliessend wird eine automatisierte Installationsvorrichtung in den Aufzugschacht gebracht, welche die restlichen Führungsschienenstücke der beiden Führungsschienen automatisiert an den Schachtwänden fixiert. Die EP 3085658 B1 enthält keine Hinweise über eine Auswahl oder Prüfung der Fixierungen der Führungsschienen an den Schachtwänden.

Demgegenüber ist es insbesondere die Aufgabe der Erfindung, ein Verfahren zur zumindest teilweise automatisierten Planung einer Installation von Aufzugkomponenten einer Aufzuganlage vorzuschlagen, welches ermöglicht, dass die folgende Installation erfolgreich und effizient ausgeführt werden kann. Erfindungsgemäss wird diese Aufgabe mit einem Verfahren mit den Merkmalen des Anspruchs 1 gelöst.

Das erfindungsgemässe Verfahren zur zumindest teilweise automatisierten Planung einer Installation von Aufzugkomponenten einer Aufzuganlage in einem von Schachtwänden begrenzten Aufzugschacht weist folgende Schritte auf:
- Erfassen von Verläufen der Schachtwände,
- Bestimmen von Positionen von Türöffnungen des Aufzugschachts,
- Festlegen eines Soll-Verlaufs einer Führungsschiene in Abhängigkeit von den bestimmten Positionen der Türöffnungen und
- automatisiertes Festlegen von Soll-Positionen der Aufzugkomponenten in Abhängigkeit vom festgelegten Verlauf der Führungsschiene.

Zumindest einige der zu installierenden Aufzugkomponenten sind als einstellbare Aufzugkomponenten ausgeführt, welche einen an einer Schachtwand fixierbaren Teil und einen gegenüber dem fixierbaren Teil in einem festgelegten Einstellbereich beweglichen Teil aufweisen, wobei für einstellbare Aufzugkomponenten Soll-Positionen der beweglichen Teile festgelegt werden. Erfindungsgemäss wird für eine einstellbare Aufzugkomponente, insbesondere für alle einstellbaren Aufzugkomponenten, automatisiert geprüft, ob bei einer Positionierung des beweglichen Teils der Aufzugkomponente an seiner Soll-Position der genannte Einstellbereich ausreicht, um den fixierbaren Teil an der Schachtwand zu fixieren. Die Ergebnisse der genannten Prüfung werden zur Weiterverarbeitung ausgegeben.

Durch Berücksichtigung der genannten Ergebnisse der Prüfung und Einleitung von Massnahmen, falls die Prüfung ergibt, dass der Einstellbereich einer oder mehrerer einstellbaren Aufzugkomponenten nicht ausreicht, kann gewährleistet werden, dass die einstellbaren Aufzugkomponenten an ihren Soll-Positionen an den Schachtwänden fixiert werden können und damit auch die Führungsschiene an ihrer Soll-Position angeordnet werden kann. Ohne eine derartige Prüfung wäre die Gefahr sehr hoch, dass während der Ausführung der geplanten Installation einstellbare Aufzugkomponenten nicht wie geplant installiert werden können. Dies würde aufwändige Nacharbeiten oder eine Beschaffung von anderen, passenden Aufzugkomponenten nach sich ziehen. Die erfindungsgemässe Planung der Installation ermöglicht, dass die Installation der Aufzugkomponenten mit hoher Wahrscheinlichkeit wie geplant durchgeführt werden kann, so dass zeit- und damit kostenintensive Nacharbeiten oder Unterbrechungen während der Installation vermieden werden. Die Installation führt damit sehr effizient zum gewünschten Ergebnis.

Die beschriebenen Schritte des Verfahrens werden insbesondere in der angegebenen Reihenfolge ausgeführt. Es ist aber auch eine andere Reihenfolge möglich.

Unter einer zumindest teilweise automatisierten Planung soll hier verstanden werden, dass zumindest einzelne Schritte der Planung automatisiert, beispielsweise von einem Computer oder einer Steuerungseinrichtung unter Anwendung von vorgegebenen Regeln durchgeführt werden. Der Computer oder die Steuerungseinrichtung verfügen dazu über ein Programm, in welchem die genannten Regeln kodiert sind. Bei der Planung ist auch ein Bediener beteiligt, wobei dessen Beteiligung lediglich aus dem Starten einer vollkommen automatisierten Planung bestehen kann. Darüber hinaus besteht auch die Möglichkeit, dass ein Bediener an unterschiedlichen Stellen Entscheidungen trifft, wobei er durch automatisiert zur Verfügung gestellte Informationen unterstützt wird.

Die Aufzugkomponenten, deren Installation geplant wird, sind insbesondere als so genanntes Schachtmaterial der Aufzuganlage oder als Schachttüren ausgeführt. Unter Schachtmaterial sind alle Bauteile zu verstehen, die in einem Aufzugschacht der Aufzuganlage an einer Schachtwand befestigt werden. Dazu zählen beispielsweise so genannte Schienenbügel, mittels welchen Führungsschienen der Aufzuganlage an einer Schachtwand fixiert werden. Darüber hinaus kann Schachtmaterial auch als Befestigungsmaterial für Schachttüren, Beleuchtung oder Verkabelungen ausgeführt sein. Schachttüren werden in Türöffnungen des Aufzugschachts montiert und verschliessen die Türöffnungen, wenn keine Aufzugkabine an einer Türöffnung angeordnet ist.

Unter der Planung der Installation von Aufzugkomponenten wird hier insbesondere eine Festlegung der Position und ggf. Ausrichtung oder Orientierung der einzelnen Aufzugkomponenten der fertig installierten Aufzuganlage verstanden. Darüber hinaus kann auch eine zumindest teilweise Installation mit einer automatisierten Montagevorrichtung geplant werden. Dabei können beispielsweise eine Reihenfolge der Installation der Aufzugkomponenten, eine Position der Montagevorrichtung bei der Ausführung von Installationsschritten und/oder eine Verwendung spezieller Werkzeuge festgelegt werden. Die genannte automatisierte Montagevorrichtung kann beispielsweise entsprechend einer in der WO 2017/016783 A1 beschriebenen Montagevorrichtung ausgeführt sein.

Die den Aufzugschacht begrenzenden Schachtwände sind insbesondere als massive Wände, beispielsweise aus Beton ausgeführt. Es ist aber auch möglich, dass ein Aufzugschacht zumindest in eine oder zwei Richtungen nicht von einer massiven Wand, sondern aus Streben, vorzugsweise aus Metall, begrenzt wird. Derartige Streben werden auch als so genannte Divider Beams bezeichnet. Damit kann eine den Aufzugschacht begrenzende Schachtwand auch durch Streben, insbesondere Divider Beams gebildet werden.

Beim Erfassen von Verläufen der Schachtwände werden insbesondere Positionen einer Vielzahl von einzelnen Punkten der Schachtwände erfasst. Diese Wandpunkte bilden dann eine so genannte Punktwolke, aus der die Verläufe der Schachtwände bestimmt werden. Die Erfassung der genannten Positionen kann beispielsweise mittels eines Messsystems basierend auf einem oder mehreren Laserscannern oder auf einer oder mehreren Digital-Kameras erfolgen. Das Messsystem wird dazu insbesondere innerhalb des Aufzugschachts so verlagert, so dass die Verläufe aller Schachtwände komplett erfasst werden können. Damit kann ein so genanntes digitales Modell des Aufzugschachts erzeugt werden. Das Messsystem kann beispielsweise wie ein in der WO 2018/041815 A1 beschriebenes Messsystem ausgeführt sein.

Bei der Erfassung der Verläufe der Schachtwände können auch einzelne oder mehrere Referenzelemente im Aufzugschacht angeordnet sein. Damit kann beispielsweise ein Koordinatensystem im Aufzugschacht festgelegt werden, das auch bei der später durchgeführten Installation der Aufzugelemente verwendet werden kann. Die Referenzelemente können beispielsweise in Form von im Aufzugschachts gespannten Schnüren und/oder als Kugeln und/oder sonstigen Markierungen ausgeführt sein.

Das Erfassen der Positionen der Türausschnitte kann von einem Bediener von Hand, teilweise automatisiert oder auch vollständig automatisiert durchgeführt werden. Die Erfassung der genannten Positionen erfolgt insbesondere auf Basis der erfassten Verläufe der Schachtwände. Einem Bediener können beispielsweise die Verläufe der Schachtwände auf einem Bildschirm angezeigt werden. Auf dieser Basis bestimmt er die Positionen der Türausschnitte selbsttätig und legt sie beispielsweise mit einem Mausklick fest. Es ist auch möglich, dass analog zum Vorgehen in der o. g. EP 3085658 B1 vor dem Erfassen der Verläufe der Schachtwände die Türöffnungen so markiert werden, dass die Markierungen insbesondere automatisiert erkannt werden können. Ausserdem ist eine vollkommen automatisierte Erfassung der Positionen der Türöffnungen auf Basis der erfassten Verläufe der Schachtwände möglich. Das Ergebnis dieser automatisierten Erfassung kann ggf. von einem Bediener kontrolliert und angepasst werden.

Eine Führungsschiene dient zur Führung der Aufzugkabine und ggf. eines Gegengewichts der Aufzuganlage während deren Verlagerung im Aufzugschacht. Im Folgenden werden nur Führungsschienen für die Aufzugkabine betrachtet. Die Ausführungen gelten analog auch für Führungsschienen des Gegengewichts. Eine Aufzuganlage weist üblicherweise zwei Führungsschienen für die Aufzugkabine auf. Die Positionen der Führungsschienen legen die Position und den Verfahrweg der Aufzugkabine im Aufzugschacht fest. Die Führungsschienen müssen damit so positioniert werden, dass die Aufzugkabine an den Türöffnungen des Aufzugschachts so angehalten werden können, dass ein Betreten und Verlassen der Aufzugkabine an allen Türöffnungen möglich ist und insbesondere die an den Türöffnungen angeordneten Schachttüren zusammen mit einer Kabinentür geöffnet und geschlossen werden können. Ausserdem müssen die Führungsschienen so verlaufen, dass die Aufzugkabine ohne Kollisionen mit Schachtwänden im Aufzugschacht verlagert werden kann.

Zur Festlegung der Position der Führungsschienen wird insbesondere an beiden Seiten der Türöffnungen eine Gerade durch Ecken der Türöffnungen gelegt. Dazu kann beispielsweise die Methode der kleinsten Fehlerquadrate verwendet werden. Die beiden Geraden werden so bestimmt, dass sie parallel zueinander sind. Als zusätzliche Bedingung kann insbesondere bei Aufzügen mit geringer Höhe, beispielsweise bis zu 50 m, vorgegeben werden, dass die Geraden in vertikaler Richtung verlaufen. In Abhängigkeit der Abmasse der Aufzugkabine ergeben sich damit Soll-Verläufe der Führungsschienen.

Durch den Soll-Verlauf der Führungsschienen ergeben sich Soll-Positionen von an Schachtwänden zu fixierenden Aufzugkomponenten, beispielsweise von Schienenbügeln zum Befestigen der Führungsschienen an einer Schachtwand oder von Schachttüren, die auf eine vorgegebene Weise gegenüber der Aufzugkabine und damit gegenüber den Führungsschienen ausgerichtet sein müssen. Für die Bestimmung der Soll-Positionen von Schienenbügeln kann als weitere Bedingung ein vorgegebener Abstand in vertikaler Richtung von zwei übereinander angeordneten Schienenbügeln berücksichtigt werden.

Zumindest einige der Aufzugkomponenten sind als einstellbare Aufzugkomponenten ausgeführt, welche einen an einer Schachtwand fixierbaren Teil und einen gegenüber dem fixierbaren Teil in einem festgelegten Einstellbereich beweglichen Teil aufweisen. Das bewegliche Teil ist dabei nur während der Installation der Aufzugkomponente gegenüber dem fixierbaren Teil beweglich und damit einstellbar. Im montierten Zustand der Aufzuganlage sind die beiden Teile einer einstellbaren Aufzugkomponente in einer bestimmten Position zueinander beispielsweise mittels einer Schraubverbindung fest verbunden. Die Bezeichnung einstellbare Aufzugkomponente bezieht sich also lediglich auf die Dauer der Installation. Nach Abschluss der Installation ist auch der als beweglich bezeichnete Teil in einer festgelegten Position gegenüber der Schachtwand fixiert.

Die einstellbaren Aufzugkomponenten sind insbesondere als Schienenbügel zum Befestigen der Führungsschiene an einer Schachtwand ausgeführt. Schienenbügel werden auch als Brackets bezeichnet und sind in vielen Varianten auf dem Markt erhältlich. Die Schienenbügel weisen jeweils ein Schienenbügelunterteil als fixierbares Teil und ein Schienenbügeloberteil als bewegliches Teil auf. Im montierten Zustand der Aufzuganlage ist eine Führungsschiene mittels eines geeigneten Clips mit dem Schienenbügeloberteil verbunden und damit über das Schienenbügeloberteil und das Schienenbügelunterteil an einer Schachtwand fixiert, insbesondere angeschraubt. Die Bezeichnungen Schienenbügelunterteil und Schienenbügeloberteil dienen dabei nur zur Unterscheidung der beiden Teile und sagen nichts über eine notwendige Orientierung oder Anordnung der Teile zueinander aus.

Durch die Verbindungen der Führungsschiene mit den beweglichen Teilen der Aufzugkomponente sind durch den Soll-Verlauf der Führungsschiene die Positionen der beweglichen Teile der Aufzugkomponenten festgelegt. Es wird für mindestes eine, insbesondere für jede einstellbare Aufzugkomponente automatisiert geprüft, ob bei einer Positionierung des beweglichen Teils der Aufzugkomponente an seiner Soll-Position der genannte Einstellbereich ausreicht, um den fixierbaren Teil an der Schachtwand zu fixieren. Anders ausgedrückt wird geprüft, ob die beiden Teile der Aufzugkomponente so zueinander angeordnet werden können, dass einerseits der bewegliche Teil an seiner Soll-Position angeordnet ist und andererseits der fixierbare Teil an einer Schachtwand fixiert werden kann. Ist dies der Fall, kann die entsprechende Aufzugkomponente wie gewünscht installiert werden. Im Beispiel eines Schienenbügels mit einem fixierbaren Schienenbügelunterteil und einem beweglichen Schienenbügeloberteil kann das Schienenbügeloberteil so positioniert werden, dass die Führungsschiene ihren Soll-Verlauf aufweist, das Schienenbügelunterteil an einer Schachtwand fixiert und ausserdem das Schienenbügeloberteil am Schienenbügelunterteil fixiert ist.

Die genannte Prüfung liefert ein positives Ergebnis, wenn die einstellbare Aufzugkomponente wie vorgesehen installiert werden kann, der Einstellbereich der Aufzugkomponente also ausreicht. Sie liefert ein negatives Ergebnis, wenn dies nicht möglich ist, der Einstellbereich also nicht ausreicht.

Die Ausgabe der Ergebnisse kann auf unterschiedlichste Weise erfolgen. Die Ergebnisse können beispielsweise auf einem Bildschirm, beispielsweise in Form einer Tabelle ausgegeben und von einem Bediener weiterverarbeitet werden. Es ist auch möglich, dass die genannte Ausgabe durch eine Weitergabe in elektronischer Form an ein spezielles Programmmodul erfolgt, das die Ergebnisse weiterverarbeitet.

In Ausgestaltung der Erfindung stützen sich die Aufzugkomponenten an Abstützflächen an der Schachtwand ab. Es wird eine Oberflächenkontur von Soll-Abstützflächen aus den erfassten Verläufen der Schachtwände und den Soll-Positionen der Aufzugkomponenten abgeleitet, die Oberflächenkontur der Soll-Abstützflächen automatisiert geprüft und die Ergebnisse der Prüfung der Soll-Abstützflächen zur Weiterverarbeitung ausgegeben. Damit wird es besonders wahrscheinlich, dass die Aufzugkomponenten an ihren Soll-Positionen auch tatsächlich installiert werden können.

Schachtwände, insbesondere wenn sie aus Beton bestehen, können an ihrer Oberfläche und damit in ihrer Oberflächenstruktur Unregelmässigkeiten in Form von Erhebungen, beispielsweise Absätzen oder Vertiefungen, beispielsweise Löcher aufweisen. Derartige Unregelmässigkeiten können das Fixieren von Aufzugkomponenten an einer Schachtwand erschweren oder ganz unmöglich machen. Die Unregelmässigkeiten können einerseits einen negativen Einfluss auf das Abstützen der Aufzugkomponente an der Schachtwand haben und andererseits ein Bohren von Löchern behindern, in die anschliessend Schrauben oder Ankerbolzen zum Fixieren der Aufzugelemente eingebracht werden. Mit einer Prüfung der Oberflächenkontur der Soll-Abstützfläche einer Aufzugkomponente kann sichergestellt werden, dass die Aufzugkomponente auch wie geplant an der Schachtwand fixiert, also insbesondere angeschraubt werden kann.

Die genannte Prüfung wird insbesondere für alle zu installierenden Aufzugkomponenten ausgeführt, also für einstellbare und nicht einstellbare Aufzugkomponenten. Die Prüfung liefert ein positives Ergebnis, wenn die Oberflächenkontur der Soll-Abstützfläche einer Installation der Aufzugkomponente nicht entgegensteht. Sie liefert ein negatives Ergebnis, wenn die Oberflächenkontur der genannten Installation entgegensteht.

Zur Prüfung der Oberflächenkontur werden insbesondere mittels einer ersten Erkennungsregel erste Unregelmässigkeiten in der Oberflächenkontur einer Soll-Abstützfläche erkannt. Als Ergebnis der Prüfung der Soll-Abstützflächen wird ausgegeben, ob eine Soll-Abstützfläche frei von ersten Unregelmässigkeit ist. Die Prüfung liefert damit ein positives Ergebnis, wenn die Soll-Abstützfläche keine ersten Unregelmässigkeiten aufweist und ein negatives Ergebnis, wenn sie erste Unregelmässigkeiten aufweist.

Insbesondere wird beim Bestimmen der Oberflächenkontur der Soll-Abstützflächen mit den ermittelten Positionen der o.g. Wandpunkte eine ideale Wandfläche bestimmt. Die ideale Wandfläche kann beispielsweise so bestimmt werden, dass die Summe der Quadrate der Abstände der Wandpunkte von der idealen Wandfläche minimal ist, also das Verfahren der kleinsten Fehlerquadrate verwendet wird. Es ist auch möglich, dass der so genannte RANSAC Algorithmus (englisch: "random sample consensus", deutsch etwa: "Übereinstimmung mit einer zufälligen Stichprobe") zur Bestimmung der idealen Wandfläche verwendet wird. Nach der Bestimmung der idealen Wandfläche werden die Abstände der einzelnen Wandpunkte von der idealen Wandfläche ermittelt. Diese Abstände dienen als Basis für die Erkennung von Unregelmässigkeiten in der Oberflächenkontur der Soll-Abstützflächen.

Nach dem Bestimmen der Oberflächenkontur der Soll-Abstützfläche wird diese überprüft und mittels einer ersten Erkennungsregel erste Unregelmässigkeiten in der Oberflächenkontur erkannt. Dabei kann beispielsweise eine erste Unregelmässigkeit bei einem Wandpunkt erkannt werden, wenn der Abstand des Wandpunkts zur idealen Wandfläche grösser als ein erster Schwellwert ist.

Die Prüfung der Oberflächenkontur kann insbesondere mehrstufig, im Speziellen zweistufig erfolgen. Dies kann so realisiert werden, dass in dem Fall, in dem eine Soll-Abstützfläche keine erste Unregelmässigkeit aufweist, mittels einer zweiten Erkennungsregel zweite Unregelmässigkeiten in der Oberflächenkontur der Soll-Abstützfläche erkannt werden und als Ergebnis der Prüfung der Soll-Abstützflächen ausgegeben wird, ob eine Soll-Abstützfläche frei von zweiten Unregelmässigkeit ist. Bei der ersten Prüfung kann insbesondere eine grobe und damit schnelle Prüfung durchgeführt werden. Erst wenn diese grobe Prüfung ein positives Ergebnis liefert, kann in der zweiten Prüfung genauer auf Unregelmässigkeiten geprüft werden. Damit kann die gesamte Prüfung sehr schnell und trotzdem gründlich durchgeführt werden. Es ist damit beispielsweise möglich, dass mittels der ersten Erkennungsregel nur vergleichsweise grosse Unregelmässigkeiten erkannt werden und erst mit der zweiten Erkennungsregel auch kleine Unregelmässigkeiten erkannt werden. Die ersten und zweiten Unregelmässigkeiten können insbesondere als Vorbereitung der genannten Prüfung für den kompletten Aufzugschacht bestimmt und abgespeichert werden.

Insbesondere umfasst die erste Erkennungsregel zum Erkennen von ersten Unregelmässigkeiten in der Oberflächenkontur folgende Schritte:
- Bestimmen von Wandpunkten, welche einen Abstand zur idealen Wandfläche aufweisen, der grösser als ein erster Schwellwert ist,
- Zusammenfassen von benachbarten Wandpunkten, welche die genannte Bedingung erfüllen, und
- Erkennen einer ersten Unregelmässigkeit, wenn ein Flächeninhalt der zusammengefassten Wandpunkte grösser als ein Grenz-Flächeninhalt ist.

Der erste Schwellwert beträgt beispielsweise zwischen 5 und 10 mm und der Grenz-Flächeninhalt beispielsweise zwischen 15 und 30 cm². Beim genannten Zusammenfassen der Wandpunkte werden beispielsweise die Wandpunkte zusammengefasst, welche die genannte Bedingung erfüllen und ausserdem einen Abstand zu einem anderen, die genannte Bedingung erfüllenden Wandpunkt aufweisen, der kleiner als ein Grenz-Abstand von beispielsweise 5 bis 50 mm aufweisen. Zusätzlich kann beim Zusammenfassen ein Rechteck definiert werden, das alle genannten Wandpunkt beinhaltet.

Insbesondere umfasst die zweite Erkennungsregel zum Erkennen von zweiten Unregelmässigkeiten in der Oberflächenkontur folgende Schritte:
- Bestimmen von Wandpunkten, welche einen Abstand zur idealen Wandfläche aufweisen, der grösser als ein zweiter Schwellwert ist,
- Erkennen einer zweiten Unregelmässigkeit bei jedem Wandpunkt, welcher die genannte Bedingung erfüllt.

Der zweite Schwellwert kann dabei gleich wie der genannte erste Schwellwert sein oder sich von diesem unterscheiden. Der zweite Schwellwert kann insbesondere kleiner als der erste Schwellwert sein und beispielsweise zwischen 3 und 5 mm betragen.

In Ausgestaltung der Erfindung wird im Fall einer Ausgabe eines negativen Ergebnisses für eine Aufzugkomponente, die ursprüngliche Soll-Position automatisiert auf eine neue Soll-Position der Aufzugkomponente verschoben und eine Prüfung der neuen Soll-Position durchgeführt. Damit ist bei einem negativen Ergebnis für eine Aufzugkomponente, also wenn eine Aufzugkomponente nicht wie geplant installiert werden kann, nicht direkt ein Eingreifen eines Bedieners notwendig. Das Verfahren kann damit zu einem sehr grossen Teil automatisiert ablaufen.

Die neue Soll-Position weicht insbesondere um einen festgelegten Abstand von beispielsweise 5 - 10 cm von der ursprünglichen Soll-Position ab. Die Verschiebung erfolgt insbesondere entlang dem Soll-Verlauf der Führungsschiene. Da bei einstellbaren Aufzugkomponenten die Soll-Position des beweglichen Teils festgelegt werden, wird auch bei einem Verschieben der Soll-Position der Aufzugkomponenten die Soll-Position des beweglichen Teils verschoben. Damit ändern sich auch die möglichen Soll-Abstützflächen der zugehörigen fixierbaren Teile der einstellbaren Aufzugkomponenten.

Die genannte Verschiebung der Soll-Position wird insbesondere nur innerhalb eines festgelegten Verschiebebereichs durchgeführt. Es wird ein negatives Ergebnis ausgegeben, wenn innerhalb des Verschiebebereichs keine geeignete Soll-Position gefunden werden kann. Das genannte negative Ergebnis kann als ein endgültig negatives Ergebnis bezeichnet werden, da eine weitere Verschiebung der Soll-Position nicht mehr möglich ist. Dieses Ergebnis kann speziell gekennzeichnet sein und damit auch speziell weiterverarbeitet werden.

Der genannte Verschiebebereich erstreckt sich beispielsweise 20 - 30 cm von der ursprünglichen Soll-Position in beide Richtungen entlang dem-Sollverlauf der Führungsschiene.

In Ausgestaltung der Erfindung wird im Fall einer Ausgabe eines negativen Ergebnisses für eine Aufzugkomponente automatisiert der Soll-Verlauf der Führungsschiene geändert.

Dies wird insbesondere dann durchgeführt, wenn die Prüfung für eine Aufzugkomponente ein oben beschriebenes endgültig negatives Ergebnis geliefert hat. Damit ist in besonders wenigen Fällen ein Eingreifen eines Bedieners notwendig. Das Verfahren kann damit zu einem besonders grossen Teil automatisiert ablaufen.

Nach der Änderung des Soll-Verlaufs der Führungsschiene werden die beschriebenen Prüfungen der Aufzugskomponenten erneut durchgeführt. Der Soll-Verlauf kann beispielsweise um eine festgelegte Strecke, beispielsweise 1 - 3 cm parallel zu den Türöffnungen verschoben werden.

In Ausgestaltung der Erfindung wird im Fall einer Ausgabe eines negativen Ergebnisses der Prüfung des Einstellbereichs für eine Aufzugkomponente automatisiert ein notwendiger Einstellbereich dieser Aufzugkomponente bestimmt und ausgegeben. Damit wird das Problem, dass der Einstellbereich nicht ausreicht nicht durch eine Verschiebung der Soll-Position gelöst, sondern es wird eine Aufzugkomponente mit einem ausreichenden bzw. passenden Einstellbereich verwendet. Damit wird ebenfalls sicher ermöglicht, dass die Installation auch durchgeführt werden kann. Durch die Bestimmung und die Ausgabe des notwendigen Einstellbereichs kann eine passende Aufzugkomponente besonders einfach gefunden oder notfalls speziell hergestellt werden. Eine passende Aufzugkomponente muss nicht zwingend einen grösseren Einstellbereich aufweisen, er kann sogar kleiner sein als bei der ursprünglich geplanten Aufzugkomponente. Die Anpassung kann insbesondere durch eine Anpassung des fixierbaren Teils oder des beweglichen Teils der Aufzugkomponente erfolgen. Beispielsweise kann ein Schienenbügelteil so ausgeführt sein, dass das zugehörige Schienenbügeloberteil einen grösseren Abstand zur Schachtwand aufweist.

Der notwendige Einstellbereich kann ermittelt werden, indem virtuell der einstellbare Teil der Aufzugkomponente an seiner Soll-Position und der fixierbare Teil an einer Schachtwand angeordnet wird. Der notwendige Einstellbereich muss dann mindestens so sein, dass die beiden Teile der Aufzugkomponente miteinander verbunden, also beispielsweise verschraubt werden können.

In Ausgestaltung der Erfindung werden die Positionen der Türöffnungen des Aufzugschachts automatisiert aus den erfassten Verläufen der Schachtwände bestimmt. Damit kann das Verfahren zu einem sehr grossen Teil automatisiert ablaufen. In den Verläufen der Schachtwände können automatisiert Ausnehmungen mit einer für eine Türöffnung ausreichenden Grösse und charakteristischen Form identifiziert werden. Anschliessend können Ecken der Ausnehmungen bestimmt werden.

Die automatisierte Bestimmung der Positionen der Türöffnungen ist besonders effektiv durchführbar, wenn zunächst Grobpositionen und anschliessend in einem Bereich um die Grobpositionen die Positionen der Türöffnungen bestimmt werden. Insbesondere kann die Bestimmung der Grobpositionen auf Basis von 2D-Daten und die Bestimmung der genauen Positionen der Türöffnungen im Umfeld der Grobpositionen auf Basis von 3D-Daten durchgeführt werden.

Die automatisiert bestimmten Positionen der Türöffnungen können insbesondere von einem Bediener verändert werden. Damit ist das Verfahren trotz einem hohen Automatisierungsgrad sehr flexibel.

Die automatisierte Bestimmung der Positionen der Türöffnungen ist auch unabhängig von der beschriebenen Prüfung der Einstellbereiche von einstellbaren Aufzugkomponenten durchführbar. Damit stellt ein Verfahren zur zumindest teilweise automatisierten Planung einer Installation von Aufzugkomponenten in einem von Schachtwänden begrenzten Aufzugschacht mit den Verfahrensschritten:
- Erfassen von Verläufen der Schachtwände,
- automatisiertes Bestimmen von Positionen von Türöffnungen des Aufzugschachts,
- Festlegen eines Soll-Verlaufs einer Führungsschiene in Abhängigkeit von den bestimmten Positionen der Türöffnungen,
- automatisiertes Festlegen von Soll-Positionen der Aufzugkomponenten in
Abhängigkeit vom festgelegten Verlauf der Führungsschiene, ein eigenständiges, nicht erfindungsgemäßes Verfahren dar.

In Ausgestaltung der Erfindung wird die geplante Installation zumindest teilweise von einer automatisierten Montagevorrichtung ausgeführt. Bei der Planung wird dann zusätzlich geprüft, ob die Montagevorrichtung die Aufzugkomponenten an ihren jeweiligen Soll-Positionen an den Schachtwänden installieren kann. Mit der zumindest teilweisen automatisierten Durchführung der Installation kann nicht nur die Planung, sondern auch die Installation sehr effektiv ausgeführt werden. Die genannte zusätzliche Prüfung sorgt zusätzlich dafür, dass die Installation auch sicher von der Montagevorrichtung ausgeführt werden kann.

Die Montagevorrichtung weist insbesondere eine Trägerkomponente und eine mechatronische Installationskomponente auf. Die Trägerkomponente ist dazu ausgelegt, relativ zum Aufzugschacht, d.h. beispielsweise innerhalb des Aufzugschachts, verlagert und in verschiedenen Höhen innerhalb des Aufzugschachts positioniert zu werden. Die Installationskomponente ist an der Trägerkomponente gehalten und dazu ausgelegt, einen Installationsschritt im Rahmen des Installationsvorgangs zumindest teilautomatisch, vorzugsweise vollautomatisch, auszuführen. Die Installationskomponente ist beispielsweise als ein Industrieroboter ausgeführt. Die Montagevorrichtung verfügt insbesondere über eine Verlagerungsvorrichtung, mittels welcher die Trägerkomponente im Aufzugschacht verlagert werden kann, und eine Fixierungskomponente zum Fixieren, insbesondere Verstemmen der Trägerkomponente im Aufzugschacht. Die Montagevorrichtung verfügt insbesondere über eine Steuerungseinrichtung zum Ansteuern der einzelnen Komponenten der Montagevorrichtung. Die Montagevorrichtung ist beispielsweise entsprechend einer in der WO 2017/016783 A1 beschriebenen Montagevorrichtung ausgeführt.

Zur Prüfung, ob die Montagevorrichtung die Aufzugkomponenten an ihren jeweiligen Soll-Positionen an den Schachtwänden installieren kann, wird beispielsweise eine Simulation der Montage der einzelnen Aufzugkomponenten durchgeführt. Bei der genannten Simulation wird ein rechnergestütztes Simulationstool genutzt, in dem die Montagevorrichtung und der Aufzugschacht modelliert werden. Es wird dann eine Simulation der einzelnen automatisierten Montageschritte durchgeführt. Bei der Simulation kann von einem Bediener oder automatisiert überprüft werden, ob die Montageschritte auch tatsächlich ausgeführt werden können oder ob es beispielsweise Kollisionen der Installationskomponente mit dem Aufzugschacht oder der Trägerkomponente gibt.

Weitere Vorteile, Merkmale und Einzelheiten der Erfindung ergeben sich anhand der nachfolgenden Beschreibung von Ausführungsbeispielen sowie anhand der Zeichnungen, in welchen gleiche oder funktionsgleiche Elemente mit identischen Bezugszeichen versehen sind. Die Zeichnungen sind lediglich schematisch und nicht massstabsgetreu.

Dabei zeigen:
- Fig. 1: ein Messsystem zur Erfassen von Verläufen von Schachtwänden in einem Aufzugschacht einer Aufzuganlage,
- Fig. 2: Türausschnitte des Aufzugschachts aus Fig. 1,
- Fig. 3: eine Sicht von oben in einen Aufzugschacht mit zwei Führungsschienen,
- Fig. 4: eine mit Schienenbügeln an eine Schachtwand fixierte Führungsschiene,
- Fig. 5: ein Schienenbügel an einer Schachtwand in einer Sicht von vorne,
- Fig. 6: eine Schnittdarstellung des Schienenbügels aus Fig. 5,
- Fig. 7: ein Ausschnitt einer Schachtwand mit Unregelmässigkeiten in der Oberflächenkontur,
- Fig. 8: eine perspektivische Ansicht eines Aufzugschachts einer Aufzuganlage mit einer darin aufgenommenen Montagevorrichtung und
- Fig. 9: eine perspektivische Ansicht der Montagevorrichtung aus Fig. 8.

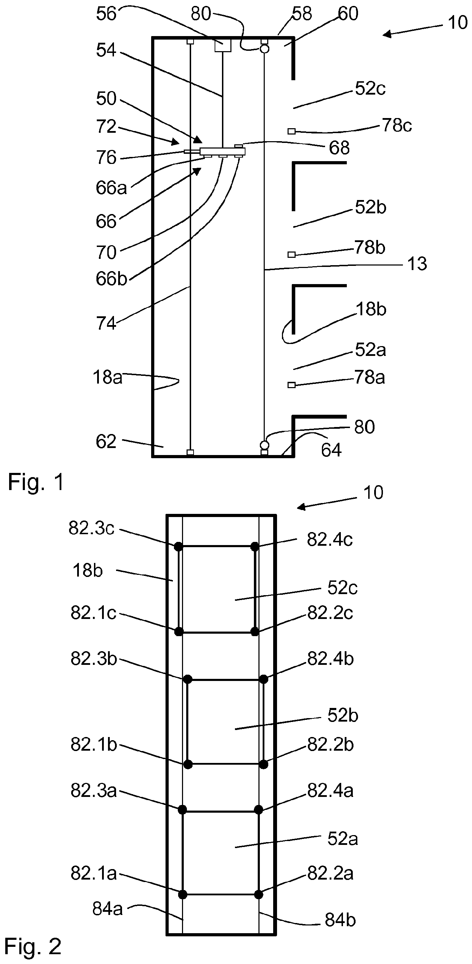

Bei einem Verfahren zur zumindest teilweise automatisierten Planung einer Installation von Aufzugkomponenten in einem von Schachtwänden begrenzten Aufzugschacht wird in einem ersten Verfahrensschritt der Aufzugsschacht vermessen, wobei Verläufe der Schachtwände erfasst werden. In Fig. 1 ist ein in einem Aufzugschacht 10 angeordnetes Messsystem 50 dargestellt. Der vertikal ausgerichtete Aufzugschacht 10 wird von vier aus Beton ausgeführten Schachtwänden begrenzt, wobei in der Fig. 1 nur eine hintere Schachtwand 18a und eine vordere Schachtwand 18b dargestellt sind. Die vordere Schachtwand 18b weist insgesamt drei übereinander angeordnete Türöffnungen 52a, 52b, 52c auf. Im fertig montierten Zustand der Aufzuganlage sind in den Türöffnungen 52a, 52b, 52c Schachttüren angeordnet, welche den Aufzugschacht 10 abschliessen und den Zugang zu einer in Fig. 1 nicht dargestellten Aufzugkabine der Aufzuganlage nur freigeben, wenn die Aufzugkabine an der entsprechenden Schachttür positioniert ist.

Das Messsystem 50 ist in diesem Fall beispielhaft als ein optisch inertiales Messsystem ausgeführt, das über ein Seil 54 und eine Winde 56 an einer Schachtdecke 58 eines Schachtkopfs 60 des hauptsächlich quaderförmigen Aufzugschachts 10 aufgehängt ist. Gegenüber dem Schachtkopf 60 weist der Aufzugschacht 10 eine Schachtgrube 62 auf, die von einem Schachtboden 64 abgeschlossen wird.

Das Messsystem 50 weist ein Kamerasystem mit mehreren, insbesondere vier oder fünf digitalen Stereo-Kameras auf. Die Stereo-Kameras sind so angeordnet, dass alle Schachtwände erfasst werden können. Beispielhaft wird im Folgenden auf eine digitale Stereo-Kamera 66 mit einer ersten Kamera 66a und einer zweiten Kamera 66b eingegangen. Die Stereo-Kamera 66 ist so ausgeführt, dass sie im dargestellten Zustand Ausschnitte aller vier Schachtwände erfassen kann. Die Stereo-Kamera 66 ist signaltechnisch mit einer Auswerteeinheit 68 des Messsystems 50 verbunden, die die von der Stereo-Kamera 66 erfassten Bilder empfängt und auswertet. Die Auswerteeinheit 68 sucht in den Bildern nach markanten Punkten, beispielsweise Ecken oder Erhebungen in den Schachtwänden. Sobald sie einen markanten Punkt in beiden Bildern der Kameras 66a, 66b identifiziert hat, kann sie aus dem bekannten Abstand der beiden Kameras 66a, 66b zueinander und der verschiedenen Lage des markanten Punkts in beiden Bildern, mittels Triangulation die Lage des markanten Punkts gegenüber den Kameras 66a, 66b und damit gegenüber dem Messsystem 50 bestimmen. Ein markanter Punkt kann auch als ein Wandpunkt einer Schachtwand bezeichnet werden.

Zwischen den beiden Kameras 66a, 66b ist eine inertiale Messeinheit 70 angeordnet. Die inertiale Messeinheit 70 verfügt über drei nicht dargestellte, jeweils senkrecht zueinander angeordnete Beschleunigungssensoren und jeweils drei ebenfalls nicht dargestellte, senkrecht zueinander angeordnete Drehratensensoren, mittels welchen die Beschleunigungen in x-, y- und z-Richtung und die Drehbeschleunigungen um die x-, y- und z-Achse bestimmt werden. Aus den gemessenen Beschleunigungen kann die inertiale Messeinheit 70 ausgehend von einer Startposition seine Position und damit auch die Position des Messsystems 50 abschätzen und an die Auswerteeinheit 68 des Messsystems 50 übermitteln.

Zur genaueren Bestimmung der Position des Messsystems 50 in vertikaler Richtung im Aufzugschacht 10 ist das Messsystem 50 mit einer Positionsbestimmungseinheit 72 gekoppelt. Die Positionsbestimmungseinheit 72 verfügt über ein vertikal ausgerichtetes Codeband 74, das zwischen Schachtboden 64 und Schachtdecke 58 gespannt ist. Das Codeband 74 weist nicht sichtbare magnetische Codemarken auf, welche eine Information über die Position in vertikaler Richtung repräsentieren. Die Positionsbestimmungseinheit 72 weist ausserdem eine am Messsystem 50 angeordnete Leseeinheit 76 auf, durch die das Codeband 74 durchgeführt ist. Die Leseeinheit 76 liest Informationen in Form der magnetischen Codemarken des Codebands 74 aus und kann damit sehr genau die Position der Leseeinheit 76 und damit des Messsystems 50 in vertikaler Richtung bestimmen.

Die mittels der Positionsbestimmungseinheit 72 ermittelte Position des Messsystems 50 in vertikaler Richtung wird als die korrekte Position des Messsystems 50 angesehen und ersetzt damit die mittels der inertialen Messeinheit 70 abgeschätzte Position der Messeinheit 50 in vertikaler Richtung.

Aus der wie oben beschrieben bestimmten Position des Messsystems 50 und der mittels Triangulation bestimmten Lage eines markanten Punkts gegenüber dem Messsystem 50 bestimmt die Auswerteeinheit 68 die absolute Position des markanten Punkts, also eines Wandpunkts. Die Auswerteeinheit 68 bestimmt so die Positionen einer Vielzahl von Wandpunkten und erstellt so ein digitales Modell des Aufzugschachts 10, das zunächst aus einer Vielzahl von einzelnen Punkten, also einer so genannten Punktwolke besteht. Um den ganzen Aufzugschacht 10 zu vermessen, wird das Messsystem 50 von der Winde 56 von oben nach unten im Aufzugschacht 10 verlagert.

Statt oder ergänzend zur Verwendung der Positionsbestimmungseinheit 72 können weitere Informationen und Hilfsmittel zur Vermessung des Aufzugschachts 10 verwendet werden. Derartige Hilfsmittel sind ebenfalls in der Fig. 1 dargestellt. Im Bereich der Schachtöffnungen 52a, 52b, 52c ist an einer Schachtwand jeweils ein Referenzelement in Form einer Markierung 78a, 78b, 78c angeordnet. Die Markierungen 78a, 78b, 78c sind dabei insbesondere als so genannte Meterrisse ausgeführt, die einen Abstand von einem Meter vom späteren Bodenbelag kennzeichnen. Zu den Markierungen 78a, 78b, 78c ist jeweils die absolute Höhe über Normal-Null oder die relative Höhe über dem Schachtboden 64 bekannt. Damit sind die Positionen der Markierungen 78a, 78b, 78c in vertikaler Richtung innerhalb des Aufzugschachts 10 bekannt. Die Auswerteeinheit 68 kann die Lage einer Markierung 78a, 78b, 78c gegenüber dem Messsystem 50 wie oben beschrieben bestimmen und auf Basis der bekannten Position der Markierung 78a, 78b, 78c in vertikaler Richtung und der genannten Lage auf die tatsächliche Position des Messsystems 50 in vertikaler Richtung zurückschliessen. Diese so bestimmte tatsächliche Position des Messsystems 50 wird dann für die Vermessung des Aufzugschachts 10 verwendet.

Ergänzend oder zusätzlich zu den Markierungen 78a, 78b, 78c kann zwischen Schachtboden 64 und Schachtdecke 58 ein, insbesondere zweilanggestreckte Referenzelemente in Form von zwei Seilen 13 gespannt sein. Die Seile 13 weisen insbesondere einen Durchmesser von ca. 8 - 12 mm auf. Die Seile 13 verlaufen damit nebeneinander in vertikaler Richtung. Im Bereich des Schachtbodens 64 und der Schachtdecke 58 ist jeweils eine Markierung in Form einer Kugel 80 angeordnet. Mittels der Seile 13 und der Kugeln 80 kann die Auswerteeinheit 68 ein Koordinatensystem definieren, das auch bei einer späteren Installation der Aufzuganlage verwendet werden kann. Statt der genannten Kugeln können die Seile auch ein Muster aufweisen, das von der Auswerteeinheit erkannt und ausgewertet werden kann.

Nach dem Vermessen des Aufzugschachts 10, also nach Erfassen der beschriebenen Punktwolke werden die erfassten Daten nachbearbeitet. Diese Nachbearbeitung wird nicht von der Auswerteeinheit 68 durchgeführt, sondern von einem nicht dargestellten leistungsstärkeren Rechner bzw. Computer. Für derartige Nachbearbeitungen sind auf dem Markt verschiedene leistungsfähige Programme verfügbar. Die Übertragung der Daten der Punktwolke von der Auswerteeinheit 68 auf den genannten Rechner kann beispielsweise über eine drahtlose Datenverbindung oder einen Datenspeicher, beispielsweise einen USB-Speicherstick erfolgen.

Auf dem genannten Rechner wird auch der zweite Verfahrensschritt der zumindest teilweise automatisierten Planung der Installation von Aufzugkomponenten durchgeführt. Dazu werden automatisiert die Positionen der Türöffnungen 52a, 52b, 52c bestimmt. Diese sind in Fig. 2 in einer Sicht von vorne dargestellt. Die Positionen der Türöffnungen 52a, 52b, 52c werden dabei über die Positionen der vier Ecken 82.1a, 82.2a, 82.3a, 82.4a, 82.1b, 82.2b, 82.3b, 82.4b, 82.1c, 82.2c, 82.3c, 82.4c der hauptsächlich rechteckigen Türöffnungen 52a, 52b, 52c bestimmt. Dazu wird von einem Computerprogramm der Verlauf der vorderen Schachtwand 18b ausgewertet. In einem ersten Schritt werden auf Basis von 2D-Daten des Verlaufs der vorderen Schachtwand 18b jeweils Grobpositionen der vier Ecken 82.1a, 82.2a, 82.3a, 82.4a, 82.1b, 82.2b, 82.3b, 82.4b, 82.1c, 82.2c, 82.3c, 82.4c bestimmt. Anschliessend werden die genauen Positionen der vier Ecken 82.1a, 82.2a, 82.3a, 82.4a, 82.1b, 82.2b, 82.3b, 82.4b, 82.1c, 82.2c, 82.3c, 82.4c im Umfeld der genannten Grobpositionen auf Basis von 3D-Daten bestimmt. Die bestimmten Positionen der Ecken 82.1a, 82.2a, 82.3a, 82.4a, 82.1b, 82.2b, 82.3b, 82.4b, 82.1c, 82.2c, 82.3c, 82.4c werden auf einem nicht dargestellten Bildschirm des Rechners angezeigt. Falls notwendig, also wenn die automatische Bestimmung der Positionen kein zufriedenstellendes Ergebnis geliefert hat, kann ein Bediener die Positionen ändern.

Statt die Positionen der Türöffnungen 52a, 52b, 52c automatisiert zu bestimmen, kann dies auch von einem Bediener auf Basis der nachbearbeiteten Punktwolke von Hand durchgeführt werden.

Auf dem genannten Rechner wird auch der dritte Verfahrensschritt der zumindest teilweise automatisierten Planung der Installation von Aufzugkomponenten durchgeführt. Zur Festlegung der Position der Führungsschienen wird automatisiert an beiden Seiten der Türöffnungen 52a, 52b, 52c eine Gerade durch Ecken der Türöffnungen 52a, 52b, 52c gelegt. Es wird also eine erste, linke Gerade 84a durch die Ecken 82.1a, 82.3a, 82.1b, 82.3b, 82.1c, 82.3c und eine zweite, rechte Gerade 84b durch die Ecken 82.2a, 82.4a, 82.2b, 82.4b, 82.2c, 82.4c gelegt. Dazu wird die Methode der kleinsten Fehlerquadrate verwendet. Die beiden Geraden werden also so festgelegt, dass die Summe der Quadrate der Abstände der genannten Ecken von der jeweiligen Gerade minimal ist. Die beiden Geraden 84a, 84b werden ausserdem so bestimmt, dass sie parallel zueinander sind und in vertikaler Richtung verlaufen. In Abhängigkeit der Abmasse der Aufzugkabine der Aufzuganlage ergeben sich damit Soll-Verläufe von zwei Führungsschienen 86a, 86b zur Führung der Aufzugkabine.

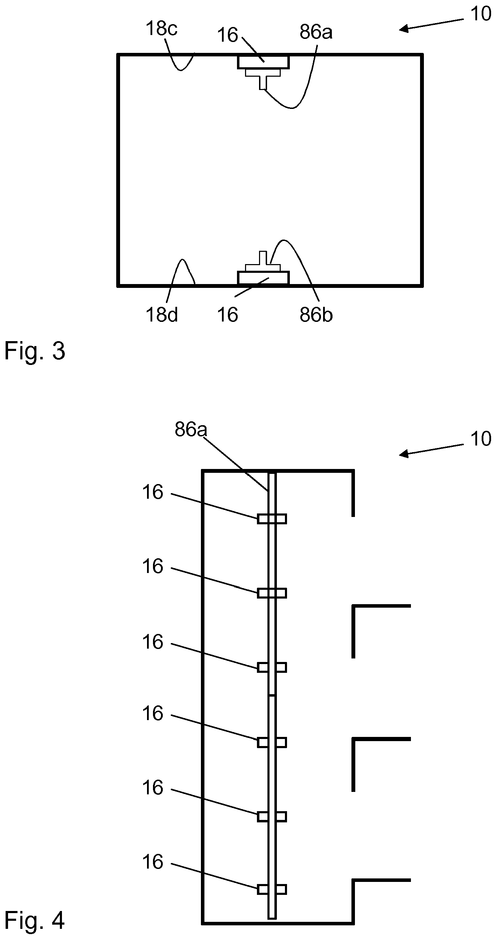

Die Führungsschienen 86a, 86b sind gemäss Fig. 3 und 4 mittels einstellbarer Aufzugkomponenten in Form von Schienenbügeln 16 an seitlichen Schachtwänden 18c, 18d fixiert. Damit die Führungsschienen 86a, 86b gemäss ihrem Soll-Verlauf verlaufen können, werden in einem vierten Verfahrensschritt der zumindest teilweise automatisierten Planung der Installation von Aufzugkomponenten automatisiert Soll-Positionen der Schienenbügel 16 bestimmt. Neben der Position in horizontaler Richtung (x-, y- Richtung) wird auch eine Position in vertikaler Richtung (z-Richtung) bestimmt. Die Position in vertikaler Richtung wird dabei so festgelegt, dass zwei übereinander angeordnete Schienenbügel 16 einen festgelegten Abstand zueinander aufweisen.

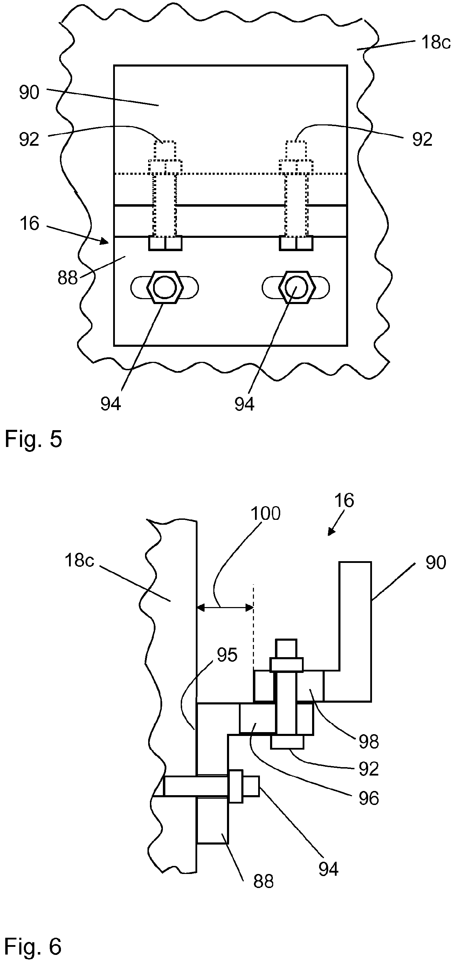

Gemäss den Fig. 5 und 6 besteht ein Schienenbügel 16 aus einem Schienenbügelunterteil 88 und einem Schienenbügeloberteil 90, welche mittels zwei Schrauben-Mutter-Verbindungen 92 miteinander verschraubt sind. Im montierten Zustand ist das Schienenbügelunterteil 88 mittels einer Bolzen-Schrauben-Verbindung 94 an der Schachtwand 18c fixiert. Dabei liegt eine Anlagefläche 95 des Schienenbügelunterteils 88 an der Schachtwand 18c an. Das Schienenbügelunterteil 88 ist damit ein fixierbares Teil der als Schienenbügel ausgeführten Aufzugkomponente. Am Schienenbügeloberteil 90 ist im montierten Zustand der Aufzuganlage die in den Fig. 5 und 6 nicht dargestellte Führungsschiene 86a fixiert. Die Position des Schienenbügeloberteils 90 legt damit den Verlauf der Führungsschiene 86a fest. Damit ergibt sich aus dem Soll-Verlauf der Führungsschiene 86a auch eine Soll-Position des Führungsschienenoberteils 90.

Das Schienenbügelunterteil 88 weist ein erstes Langloch 96 und das Schienenbügeloberteil 90 ein korrespondierendes zweites Langloch 98 auf. Die Schrauben-Mutter-Verbindung 92 verläuft durch die beiden Langlöcher 96, 98. So lange die Schrauben-Mutter-Verbindung 92 nicht fest angezogen ist, ermöglicht diese Anordnung ein Verschieben des Schienenbügeloberteils 90 gegenüber dem Schienenbügelunterteil 88, das Schienenbügeloberteil 90 kann damit gegenüber dem Schienenbügelunterteil 88 eingestellt werden. Das Schienenbügeloberteil 90 ist damit ein bewegliches Teil der als Schienenbügel ausgeführten Aufzugkomponente. Das Schienenbügeloberteil 90 hat in Fig. 6 einen maximalen Abstand von der Schachtwand 18c. Im anderen, nicht dargestellten Extremfall liegt das Schienenbügeloberteil 90 an der Schachtwand 18c an. Damit ergibt sich der mit dem Pfeil 100 symbolisierte Einstellbereich des Schienenbügels 16.

Beim vierten Verfahrensschritt der zumindest teilweise automatisierten Planung der Installation von Aufzugkomponenten wird von einem auf dem genannten Rechner ausgeführten Programm automatisch geprüft, ob bei einer Positionierung des Schienenbügeloberteils 90 an seiner Soll-Position der Einstellbereich 100 des Schienenbügels 16 ausreicht, um das Schienenbügelunterteil 88 an der Schachtwand 18c zu fixieren. Diese Prüfung wird für alle zu installierenden Schienenbügel 16 durchgeführt und die Ergebnisse der Prüfung werden zur Weiterverarbeitung, insbesondere an ein anderes auf dem genannten Rechner laufendes Programm oder am Bildschirm ausgegeben.

Zusätzlich wird automatisch geprüft, ob Verstellbereiche der Schachttüren ausreichen, um sie in einer sich aus dem Soll-Verlauf der Führungsschienen 86a, 86b ergebenden Position in den Türöffnungen 52a, 52b, 52c zu montieren.

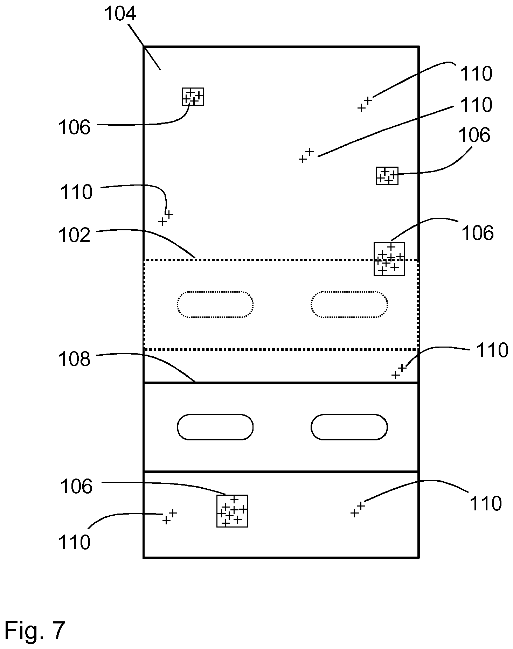

Wie beschrieben, liegt die Anlagefläche 95 des Schienenbügelunterteils 88 an der Schachtwand 18c an und stützt sich damit an der Schachtwand 18c ab. Genauer ausgedrückt liegt die Anlagefläche 95 an einer Abstützfläche der Schachtwand 18c an. Aus der Soll-Position des Schienenbügeloberteils 90 und der möglichen Kopplung zum Schienenbügelunterteil 88 ergibt sich eine Soll-Abstützfläche 102 an der Schachtwand, die in Fig. 7 dargestellt ist. Gemäss einem weiteren Verfahrensschritt der zumindest teilweise automatisierten Planung der Installation von Aufzugkomponenten wird eine Oberflächenkontur der Soll-Abstützfläche 102 automatisch geprüft. Es wird dabei geprüft, ob die Oberflächenkontur Unregelmässigkeiten aufweist, die eine Fixierung des Schienenbügelunterteils 88 an der Schachtwand 19c behindern können.

Zunächst wird beim Bestimmen der Oberflächenkontur der Soll-Abstützfläche 102 mit den ermittelten Positionen der o.g. Wandpunkte eine ideale Wandfläche bestimmt. Die ideale Wandfläche wird dabei nicht nur für die Soll-Abstützfläche 102 bestimmt, sondern für einen so genannten Verschiebebereich 104, innerhalb dessen die Soll-Abstützfläche nach unten und oben verschoben werden kann. Die ideale Wandfläche wird mit dem RANSAC Algorithmus bestimmt. Nach der Bestimmung der idealen Wandfläche werden die Abstände der einzelnen Wandpunkte von der idealen Wandfläche ermittelt. Diese Abstände dienen als Basis für die Erkennung von Unregelmässigkeiten in der Oberflächenkontur der Soll-Abstützfläche 102.

Nach dem Bestimmen der Oberflächenkontur der Soll-Abstützfläche 102 wird diese überprüft und mittels einer ersten Erkennungsregel erste Unregelmässigkeiten in der Oberflächenkontur erkannt. Die erste Erkennungsregel umfasst folgende Schritte:
- Bestimmen von Wandpunkten, welche einen Abstand zur idealen Wandfläche aufweisen, der grösser als ein erster Schwellwert ist,
- Zusammenfassen von benachbarten Wandpunkten, welche die genannte Bedingung erfüllen, und
- Erkennen einer ersten Unregelmässigkeit, wenn ein Flächeninhalt der zusammengefassten Wandpunkte grösser als ein Grenz-Flächeninhalt ist.

Der erste Schwellwert beträgt beispielsweise zwischen 5 und 10 mm und der Grenz-Flächeninhalt beispielsweise zwischen 15 und 30 cm². Beim genannten Zusammenfassen der Wandpunkte werden die Wandpunkte zusammengefasst, welche die genannte Bedingung erfüllen und ausserdem einen Abstand zu einem anderen, die genannte Bedingung erfüllenden Wandpunkt aufweisen, der kleiner als ein Grenz-Abstand von beispielsweise 5 bis 50 mm aufweisen. Zusätzlich wird beim Zusammenfassen ein Rechteck definiert werden, das alle genannten Wandpunkt beinhaltet. Damit ergeben sich im in Fig, 7 dargestellten Beispiel insgesamt vier erste Unregelmässigkeiten 106.

Nach der Bestimmung der ersten Unregelmässigkeiten wird automatisiert geprüft, ob in der Soll-Abstützfläche 102 eine erste Unregelmässigkeit 106 liegt. Das ist hier der Fall, so dass automatisiert die Soll-Position des Schienenbügeloberteils in vertikaler Richtung nach unten verschoben wird. Dies führt dazu, dass die Soll-Abstützfläche 102 ebenfalls in vertikaler Richtung nach unten auf eine neue Soll-Abstützfläche 108 verschoben wird. Dabei wird davon ausgegangen, dass der Verstellbereich 100 des Schienenbügels 16 ausreicht, um das Schienenbügelunterteil 88 an der Schachtwand 18c zu fixieren.

Anschliessend wird die neue Soll-Abstützfläche 108 ebenfalls auf erste Unregelmässigkeiten 106 geprüft. In der neuen Soll-Abstützfläche 108 liegt keine erste Unregelmässigkeit 106, so dass eine weitere Prüfung durchgeführt wird. Dazu werden mittels einer zweiten Erkennungsregel zweite Unregelmässigkeiten erkannt.

Die zweite Erkennungsregel zum Erkennen von zweiten Unregelmässigkeiten in der Oberflächenkontur umfasst folgende Schritte:
- Bestimmen von Wandpunkten, welche einen Abstand zur idealen Wandfläche aufweisen, der grösser als ein zweiter Schwellwert ist,
- Erkennen einer zweiten Unregelmässigkeit bei jedem Wandpunkt, welcher die genannte Bedingung erfüllt.

Der zweite Schwellwert beträgt beispielsweise zwischen 3 und 5 mm. Damit ergeben sich im in Fig, 7 dargestellten Beispiel eine Reihe zweite Unregelmässigkeiten 110.

Nach der Bestimmung der zweiten Unregelmässigkeiten wird automatisiert geprüft, ob in der neuen Soll-Abstützfläche 108 eine zweite Unregelmässigkeit 110 liegt. Das ist hier nicht der Fall, so die neue Soll-Abstützfläche 108 als Abstützfläche 108 akzeptiert wird. Die Prüfung der Oberflächenkontur der neuen Soll-Abstützfläche 108 für das Schienenbügelunterteil 88 liefert damit ein positives Ergebnis.

Wäre in der neuen Soll-Abstützfläche 108 wieder eine erste Unregelmässigkeit 106 oder eine zweite Unregelmässigkeit 110 gelegen, so wäre die Soll-Position des Schienenbügeloberteils 90 und damit die Soll-Abstützfläche erneut verschoben und die neue Soll-Abstützfläche wieder geprüft worden. Dieser Vorgang wird so lange wiederholt, bis eine Abstützfläche gefunden wird oder das obere und untere Ende des Verschiebebereichs 104 erreicht wurde.

Die beschriebene Prüfung der Oberflächenkontur wird für alle zu installierenden Aufzugkomponenten, also für verstellbare und nicht verstellbare Aufzugkomponenten, durchgeführt. Liefern alle Prüfungen ein positives Ergebnis, kann die Installation so durchgeführt werden. Das Ergebnis wird einem Bediener auf einem Bildschirm des Rechners angezeigt.

Falls für eine oder mehrere Aufzugkomponenten der Einstellbereich nicht ausreicht oder keine passende Abstützfläche gefunden werden kann, so können automatisiert die Soll-Verläufe der Führungsschienen verändert und die gesamten Prüfungen erneut durchgeführt werden. Die Soll-Verläufe können beispielsweise um eine festgelegte Strecke, beispielsweise 1 - 3 cm parallel zu den Türöffnungen verschoben werden.

Falls für eine oder mehrere Aufzugkomponenten der Einstellbereich nicht ausreicht, kann auch automatisiert ein notwendiger Einstellbereich dieser Aufzugkomponente bestimmt und ausgegeben werden. Welche Variante ausgeführt wird, kann der Bediener durch entsprechende Eingaben an dem Rechner festlegen.

Zumindest einige Schachtkomponenten sollen von einer automatisierten Montagevorrichtung mit einer Installationskomponente ausgeführt werden. Damit dies erfolgreich durchgeführt werden kann, wird abschliessend geprüft, ob die Montagevorrichtung die Aufzugkomponenten an ihren jeweiligen Soll-Positionen an den Schachtwänden installieren kann.

Dazu wird eine Simulation der Montage der einzelnen Aufzugkomponenten durchgeführt. Bei der Simulation wird vom Bediener oder automatisiert überprüft, ob die Montageschritte auch tatsächlich ausgeführt werden können oder ob es beispielsweise Kollisionen der Installationskomponente mit dem Aufzugschacht oder der Trägerkomponente gibt.

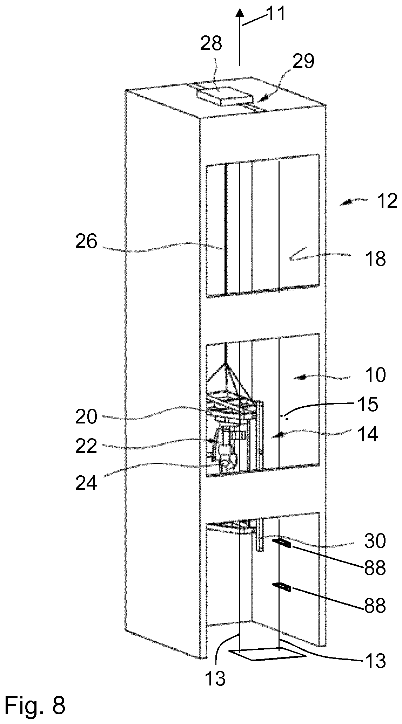

In Fig. 8 ist eine in einem Aufzugschacht 10 einer Aufzuganlage 12 angeordnete automatisierte Montagevorrichtung 14 dargestellt, mittels welcher Schienenbügelunterteile 88 an einer Schachtwand 18c fixiert werden können. Dazu können von der Montagevorrichtung 14 Löcher 15 in die Schachtwand 18 gebohrt werden. Der Aufzugschacht 10 erstreckt sich in einer Haupterstreckungsrichtung 11, die in der Fig. 8 vertikal ausgerichtet ist. Über die Schienenbügelunterteile 88 können in einem späteren Montageschritt nicht dargestellte Führungsschienen der Aufzuganlage 12 an der Schachtwand 18 fixiert werden. Die Montagevorrichtung 14 weist eine Trägerkomponente 20 und eine mechatronische Installationskomponente 22 auf. Die Trägerkomponente 20 ist als Gestell ausgeführt, an dem die mechatronische Installationskomponente 22 montiert ist. Dieses Gestell weist Abmessungen auf, die ermöglichen, die Trägerkomponente 20 innerhalb des Aufzugschachts 10 vertikal zu verlagern, das heisst beispielsweise zu unterschiedlichen vertikalen Positionen an verschiedenen Stockwerken innerhalb eines Gebäudes zu verfahren. Die mechatronische Installationskomponente 22 ist im dargestellten Beispiel als Industrieroboter 24 ausgeführt, der nach unten hängend an dem Gestell der Trägerkomponente 20 angebracht ist. Ein Arm des Industrieroboters 24 kann dabei relativ zu der Trägerkomponente 20 bewegt werden und beispielsweise hin zur Schachtwand 18 des Aufzugschachts 10 verlagert werden.

Die Trägerkomponente 20 ist über ein als Tragmittel 26 dienendes Stahlseil mit einer Verlagerungskomponente 28 in Form einer motorisch angetriebenen Seilwinde verbunden, welche oben an dem Aufzugschacht 10 an einer Haltestelle 29 an der Decke des Aufzugschachts 10 angebracht ist. Mithilfe der Verlagerungskomponente 28 kann die Montagevorrichtung 14 innerhalb des Aufzugschachts 10 in Haupterstreckungsrichtung 11 des Aufzugschachts 10, also vertikal über eine gesamte Länge des Aufzugschachts 10 hin verlagert werden.

Die Montagevorrichtung 14 weist ferner eine Fixierkomponente 30 auf, mithilfe derer die Trägerkomponente 20 innerhalb des Aufzugschachts 10 in seitlicher Richtung, das heisst in horizontaler Richtung, fixiert werden kann.

Im Aufzugschacht 10 sind über dessen gesamte Länge zwei Referenzelemente 13 in Form von Schnüren gespannt, die entlang der Haupterstreckungsrichtung 11 ausgerichtet sind. Diese Schnüre 13 sind insbesondere dieselben, die bereits beim Vermessen des Aufzugschachts 10 im Aufzugschacht 10 gespannt waren.

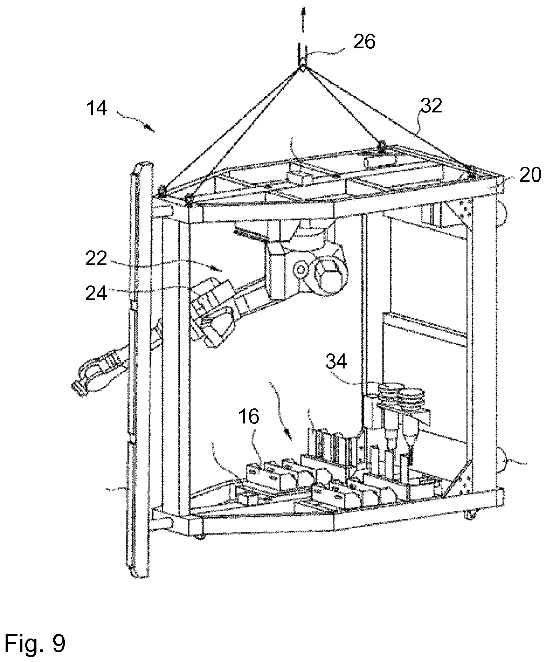

Fig. 9 zeigt eine vergrößerte Ansicht einer Montagevorrichtung 14.

Die Trägerkomponente 20 ist als käfigartiges Gestell ausgebildet, bei dem mehrere horizontal und vertikal verlaufende Holme eine mechanisch belastbare Struktur bilden. Oben an der käfigartigen Trägerkomponente 20 sind Halteseile 32 angebracht, welche mit dem Tragmittel 26 verbunden werden können.

In der dargestellten Ausführungsform ist die mechatronische Installationskomponente 22 mithilfe eines Industrieroboters 24 ausgeführt. In dem dargestellten Beispiel ist der Industrieroboter 24 mit mehreren um Schwenkachsen verschwenkbaren Roboterarmen ausgestattet. Beispielsweise kann der Industrieroboter mindestens sechs Freiheitsgrade aufweisen, das heisst, ein von dem Industrieroboter 24 geführtes Montagewerkzeug 34 kann mit sechs Freiheitsgraden bewegt werden, das heisst beispielsweise mit drei Rotationsfreiheitsgraden und drei Translationsfreiheitsgraden. Beispielsweise kann der Industrieroboter als Vertikal-Knickarmroboter, als Horizontal-Knickarmroboter oder als SCARA-Roboter oder als kartesischer Roboter bzw. Portalroboter ausgeführt sein.

Der Roboter kann an seinem freitragenden Ende mit verschiedenen Montagewerkzeugen 34 gekoppelt werden. Die Montagewerkzeuge 34 können sich hinsichtlich ihrer Auslegung und ihres Einsatzzweckes unterscheiden. Die Montagewerkzeuge 34 können an der Trägerkomponente 20 derart gehalten werden, dass das freitragende Ende des Industrieroboters 24 an sie herangefahren werden und mit einem von ihnen gekoppelt werden kann. Der Industrieroboter 24 kann hierzu beispielsweise über ein Werkzeugwechselsystem verfügen, das so ausgebildet ist, dass es mindestens die Handhabung mehrerer solcher Montagewerkzeuge 34 ermöglicht.

Abschliessend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Der Schutzumfang der Erfindung wird durch die beigefügten Ansprüche bestimmt. Bezugszeichen in den Ansprüchen sind nicht als Einschränkung anzusehen.

## Patentansprüche

1. Verfahren zur zumindest teilweise automatisierten Planung einer Installation von Aufzugkomponenten (16) in einem von Schachtwänden (18a, 18b, 18c, 18d) begrenzten Aufzugschacht (10) mit folgenden Schritten:
- Erfassen von Verläufen der Schachtwände (18a, 18b, 18c, 18d),
- Bestimmen von Positionen von Türöffnungen (52a, 52b, 52c) des Aufzugschachts (10),
- Festlegen eines Soll-Verlaufs einer Führungsschiene (86a, 86b) in Abhängigkeit von den bestimmten Positionen der Türöffnungen (52a, 52b, 52c) und
- automatisiertes Festlegen von Soll-Positionen der Aufzugkomponenten (16) in Abhängigkeit vom festgelegten Verlauf der Führungsschiene (86a, 86b),
wobei zumindest einige der zu installierenden Aufzugkomponenten (16) als einstellbare Aufzugkomponenten ausgeführt sind, welche einen an einer Schachtwand (18a, 18b, 18c, 18d) fixierbaren Teil (88) und einen gegenüber dem fixierbaren Teil (88) in einem festgelegten Einstellbereich (100) beweglichen Teil (90) aufweisen, und für einstellbare Aufzugkomponenten (16) Soll-Positionen der beweglichen Teile (90) festgelegt werden **dadurch gekennzeichnet, dass**
- für eine einstellbare Aufzugkomponente (16) automatisiert geprüft wird, ob bei einer Positionierung des beweglichen Teils (90) der Aufzugkomponente (16) an seiner Soll-Position (102, 108) der genannte Einstellbereich (100) ausreicht, um den fixierbaren Teil (88) an der Schachtwand (18a, 18b, 18c, 18d) zu fixieren und
- die Ergebnisse der genannten Prüfung zur Weiterverarbeitung ausgegeben werden.

2. Verfahren nach Anspruch 1,
**dadurch gekennzeichnet, dass**
die einstellbaren Aufzugkomponenten (16) als Schienenbügel zum Befestigen der Führungsschiene (86a, 86b) an einer Schachtwand (18c, 18d) ausgeführt sind und die Schienenbügel (16) jeweils ein Schienenbügelunterteil (88) als fixiertes Teil und ein Schienenbügeloberteil (90) als bewegliches Teil aufweisen.

3. Verfahren nach Anspruch 1 oder 2,
**dadurch gekennzeichnet, dass**
sich die Aufzugkomponenten (16) an Abstützflächen (108) an der Schachtwand (18c) abstützen, eine Oberflächenkontur von Soll-Abstützflächen (102, 108) aus den erfassten Verläufen der Schachtwände (18a, 18b, 18c, 18d) und den Soll-Positionen der Aufzugkomponenten (16) abgeleitet, die Oberflächenkontur der Soll-Abstützflächen (102, 108) automatisiert geprüft und die Ergebnisse der Prüfung der Soll-Abstützflächen (102, 108) zur Weiterverarbeitung ausgegeben werden.

4. Verfahren nach Anspruch 3,
**dadurch gekennzeichnet, dass**
mittels einer ersten Erkennungsregel erste Unregelmässigkeiten (106) in der Oberflächenkontur einer Soll-Abstützfläche (102, 108) erkannt werden und als Ergebnis der Prüfung der Soll-Abstützflächen (102, 108) ausgegeben wird, ob eine Soll-Abstützfläche (102, 108) frei von ersten Unregelmässigkeit (106) ist.

5. Verfahren nach Anspruch 4,
**dadurch gekennzeichnet, dass**
in dem Fall, in dem eine Soll-Abstützfläche (102, 108) keine erste Unregelmässigkeit (106) aufweist, mittels einer zweiten Erkennungsregel zweite Unregelmässigkeiten (110) in der Oberflächenkontur der Soll-Abstützfläche (102, 108) erkannt werden und als Ergebnis der Prüfung der Soll-Abstützflächen (102, 108) ausgegeben wird, ob eine Soll-Abstützfläche (102, 108) frei von zweiten Unregelmässigkeit (110) ist.

6. Verfahren nach einem der Ansprüche 1 bis 5,
**dadurch gekennzeichnet, dass**
im Fall einer Ausgabe eines negativen Ergebnisses für eine Aufzugkomponente (16), die ursprüngliche Soll-Position automatisiert auf eine neue Soll-Position der Aufzugkomponente (16) verschoben wird und eine Prüfung der neuen Soll-Position durchgeführt wird.

7. Verfahren nach Anspruch 6,
**dadurch gekennzeichnet, dass**
die genannte Verschiebung der Soll-Position nur innerhalb eines Verschiebebereichs durchgeführt wird und ein negatives Ergebnis ausgegeben wird, wenn innerhalb des Verschiebebereichs keine geeignete Soll-Position gefunden werden kann.

8. Verfahren nach einem der Ansprüche 1 bis 7,
**dadurch gekennzeichnet, dass**
im Fall einer Ausgabe eines negativen Ergebnisses für eine Aufzugkomponente (16) automatisiert der Soll-Verlauf der Führungsschiene (86a, 86b) geändert wird.

9. Verfahren nach einem der Ansprüche 1 bis 7,
**dadurch gekennzeichnet, dass**
im Fall einer Ausgabe eines negativen Ergebnisses der Prüfung des Einstellbereichs (100) für eine Aufzugkomponente (16) automatisiert ein notwendiger Einstellbereich (100) dieser Aufzugkomponente (16) bestimmt und ausgegeben wird.

10. Verfahren nach einem der Ansprüche 1 bis 9,
**dadurch gekennzeichnet, dass**
die Positionen der Türöffnungen (52a, 52b, 52c) des Aufzugschachts automatisiert aus den erfassten Verläufen der Schachtwände (18a, 18b, 18c, 18d) bestimmt werden.

11. Verfahren nach Anspruch 10,
**dadurch gekennzeichnet, dass**
für die Bestimmung der Positionen der Türöffnungen (52a, 52b, 52c) des Aufzugschachts (10) zunächst Grobpositionen und anschliessend in einem Bereich um die Grobpositionen die Positionen der Türöffnungen (52a, 52b, 52c) bestimmt werden.

12. Verfahren nach Anspruch 10 oder 11,
**dadurch gekennzeichnet, dass**
die automatisiert bestimmten Positionen der Türöffnungen (52a, 52b, 52c) von einem Bediener verändert werden können.

13. Verfahren nach einem der Ansprüche 1 bis 12,
**dadurch gekennzeichnet, dass**
die geplante Installation zumindest teilweise von einer automatisierten Montagevorrichtung (14) ausgeführt wird und bei der Planung geprüft wird, ob die Montagevorrichtung (14) die Aufzugkomponenten (16) an ihren jeweiligen Soll-Positionen an den Schachtwänden (18a, 18b, 18c, 18d) installieren kann.

## Claims

1. Method for at least partially automated planning of an installation of elevator components (16) in an elevator shaft (10) delimited by shaft walls (18a, 18b, 18c, 18d), comprising the following steps:
- recording the course of the shaft walls (18a, 18b, 18c, 18d),
- determining positions of door openings (52a, 52b, 52c) in the elevator shaft (10),
- establishing a target course of a guide rail (86a, 86b) depending on the specific positions of the door openings (52a, 52b, 52c) and
- establishing target positions of the elevator components (16) in an automated manner depending on the established course of the guide rail (86a, 86b),
at least some of the elevator components (16) to be installed being designed as adjustable elevator components which have a part (88) that can be fixed to a shaft wall (18a, 18b, 18c, 18d) and a part (90) that is movable in an established adjustment range (100) with respect to the fixable part (88), and target positions of the movable parts (90) being established for adjustable elevator components (16),
**characterized in that**
- for an adjustable elevator component (16), an automated check is carried out to determine whether, when the movable part (90) of the elevator component (16) is positioned at its target position (102, 108), the aforementioned adjustment range (100) is sufficient to fix the fixable part (88) to the shaft wall (18a, 18b, 18c, 18d) and
- the results of the aforementioned test are output for further processing.

2. Method according to claim 1,
**characterized in that**
the adjustable elevator components (16) are designed as rail brackets for fastening the guide rail (86a, 86b) to a shaft wall (18c, 18d) and the rail brackets (16) each have a rail bracket lower part (88) as a fixed part and a rail bracket upper part (90) as a movable part.

3. Method according to either claim 1 or claim 2,
**characterized in that**
the elevator components (16) are supported on support surfaces (108) on the shaft wall (18c), a surface contour of target support surfaces (102, 108) is derived from the recorded courses of the shaft walls (18a, 18b, 18c, 18d) and the target positions of the elevator components (16), the surface contour of the target support surfaces (102, 108) is automatically checked, and the results of the check of the target support surfaces (102, 108) are output for further processing.

4. Method according to claim 3,
**characterized in that**
first irregularities (106) in the surface contour of a target support surface (102, 108) are recognized by means of a first recognition rule and the result of the test of the target support surfaces (102, 108) is output as to whether a target support surface (102, 108) is free from first irregularities (106).

5. Method according to claim 4,
**characterized in that**
if a target support surface (102, 108) does not have a first irregularity (106), second irregularities (110) in the surface contour of the target support surface (102, 108) are recognized by means of a second recognition rule and, as a result of the test of the target support surfaces (102, 108), it is output whether a target support surface (102, 108) is free of second irregularities (110).

6. Method according to any of claims 1 to 5,
**characterized in that**
if a negative result is output for an elevator component (16), the original target position is automatically shifted to a new target position of the elevator component (16) and the new target position is checked.

7. Method according to claim 6,
**characterized in that**
the aforementioned displacement of the target position is only carried out within a displacement range and a negative result is output if no suitable target position can be found within the displacement range.

8. Method according to any of claims 1 to 7,
**characterized in that**
if a negative result is output for an elevator component (16), the target course of the guide rail (86a, 86b) is changed automatically.

9. Method according to any of claims 1 to 7,
**characterized in that**
if a negative result of the check of the adjustment range (100) is output for an elevator component (16), a necessary adjustment range (100) of said elevator component (16) is automatically determined and output.

10. Method according to any of claims 1 to 9,
**characterized in that**
the positions of the door openings (52a, 52b, 52c) of the elevator shaft are automatically determined from the recorded courses of the shaft walls (18a, 18b, 18c, 18d).

11. Method according to claim 10,
**characterized in that**
to determine the positions of the door openings (52a, 52b, 52c) of the elevator shaft (10), initially rough positions and then the positions of the door openings (52a, 52b, 52c) in a region around the rough positions are determined.

12. Method according to either claim 10 or claim 11,
**characterized in that**
the automatically determined positions of the door openings (52a, 52b, 52c) can be changed by an operator.

13. Method according to any of claims 1 to 12,
**characterized in that**
the planned installation is at least partially carried out by an automated mounting device (14), and a check is carried out, during the planning, to determine whether the mounting device (14) can install the elevator components (16) at their respective target positions on the shaft walls (18a, 18b, 18c, 18d).

## Revendications

1. Procédé de planification au moins partiellement automatisée d'une installation de composants d'ascenseur (16) dans une cage d'ascenseur (10) délimitée par des parois de cage (18a, 18b, 18c, 18d), comportant les étapes suivantes :
- la détection de profils des parois de cage (18a, 18b, 18c, 18d),
- la détermination des positions des ouvertures de porte (52a, 52b, 52c) de la cage d'ascenseur (10),
- la définition d'un profil de consigne d'un rail de guidage (86a, 86b) en fonction des positions déterminées des ouvertures de porte (52a, 52b, 52c) et
- la définition automatisée des positions de consigne des composants d'ascenseur (16) en fonction du profil défini du rail de guidage (86a, 86b),
dans lequel au moins certains des composants d'ascenseur (16) à installer sont conçus sous la forme de composants d'ascenseur réglables, lesquels comportent une partie (88) pouvant être fixée à une paroi de cage (18a, 18b, 18c, 18d) et une partie (90) mobile par rapport à la partie (88) pouvant être fixée dans une plage de réglage (100) définie, et des positions de consigne des parties (90) mobiles sont définies pour les composants d'ascenseur (16) réglables, **caractérisé en ce que**,
- pour un composant d'ascenseur (16) réglable, il est vérifié de manière automatisée si, lorsque la partie (90) mobile du composant d'ascenseur (16) est positionnée à sa position de consigne (102, 108), ladite plage de réglage (100) est suffisante pour fixer la partie (88) pouvant être fixée à la paroi de cage (18a, 18b, 18c, 18d) et
- les résultats de ladite vérification sont sortis pour un traitement ultérieur.

2. Procédé selon la revendication 1,
**caractérisé en ce que**
les composants d'ascenseur (16) réglables sont conçus sous la forme des étriers de rail permettant de fixer le rail de guidage (86a, 86b) à une paroi de cage (18c, 18d) et les étriers de rail (16) comportent respectivement une partie inférieure d'étrier de rail (88) en tant que partie fixe et une partie supérieure d'étrier de rail (90) en tant que partie mobile.

3. Procédé selon la revendication 1 ou 2,
**caractérisé en ce que**
les composants d'ascenseur (16) s'appuient sur des surfaces d'appui (108) sur la paroi de cage (18c), un contour de surface des surfaces d'appui de consigne (102, 108) est dérivé à partir des profils détectés des parois de cage (18a, 18b, 18c, 18d) et des positions de consigne des composants d'ascenseur (16), le contour de surface des surfaces d'appui de consigne (102, 108) est vérifié de manière automatisée et les résultats de la vérification des surfaces d'appui de consigne (102, 108) sont sortis pour un traitement ultérieur.

4. Procédé selon la revendication 3,
**caractérisé en ce que**
des premières irrégularités (106) dans le contour de surface d'une surface d'appui de consigne (102, 108) sont détectées au moyen d'une première règle de détection et le résultat de la vérification des surfaces d'appui de consigne (102, 108) est sorti afin de savoir si une surface d'appui de consigne (102, 108) est exempte de la première irrégularité (106).

5. Procédé selon la revendication 4,
**caractérisé en ce que**
dans le cas où une surface d'appui de consigne (102, 108) ne présente pas de première irrégularité (106), des secondes irrégularités (110) dans le contour de surface de la surface d'appui de consigne (102, 108) sont détectées au moyen d'une seconde règle de détection et le résultat de la vérification des surfaces d'appui de consigne (102, 108) est sorti afin de savoir si une surface d'appui de consigne (102, 108) est exempte de la seconde irrégularité (110).

6. Procédé selon l'une quelconque des revendications 1 à 5,
**caractérisé en ce que**
dans le cas où un résultat négatif est sorti pour un composant d'ascenseur (16), la position de consigne initiale est décalée de manière automatisée vers une nouvelle position de consigne du composant d'ascenseur (16) et une vérification de la nouvelle position de consigne est effectuée.

7. Procédé selon la revendication 6,
**caractérisé en ce que**
ledit décalage de la position de consigne n'est effectué que dans une plage de décalage et un résultat négatif est sorti lorsqu'aucune position de consigne appropriée ne peut être trouvée dans la plage de décalage.

8. Procédé selon l'une quelconque des revendications 1 à 7,
**caractérisé en ce que**
dans le cas où un résultat négatif est sorti pour un composant d'ascenseur (16), le profil de consigne du rail de guidage (86a, 86b) est modifié de manière automatisée.

9. Procédé selon l'une quelconque des revendications 1 à 7,
**caractérisé en ce que**
dans le cas où un résultat négatif de la vérification de la plage de réglage (100) est sorti pour un composant d'ascenseur (16), une plage de réglage (100) nécessaire dudit composant d'ascenseur (16) est déterminée et sortie de manière automatisée.

10. Procédé selon l'une quelconque des revendications 1 à 9,
**caractérisé en ce que**
les positions des ouvertures de porte (52a, 52b, 52c) de la cage d'ascenseur sont déterminées de manière automatisée à partir des profils détectés des parois de cage (18a, 18b, 18c, 18d).

11. Procédé selon la revendication 10,
**caractérisé en ce que**
pour déterminer les positions des ouvertures de porte (52a, 52b, 52c) de la cage d'ascenseur (10), des positions approximatives sont d'abord déterminées, puis les positions des ouvertures de porte (52a, 52b, 52c) sont déterminées dans une zone autour des positions approximatives.

12. Procédé selon la revendication 10 ou 11,
**caractérisé en ce que**
les positions déterminées de manière automatisée des ouvertures de porte (52a, 52b, 52c) peuvent être modifiées par un opérateur.

13. Procédé selon l'une quelconque des revendications 1 à 12,
**caractérisé en ce que**
l'installation prévue est mise en œuvre au moins partiellement par un dispositif de montage (14) automatisé et lors de la planification, il est vérifié si le dispositif de montage (14) peut installer les composants d'ascenseur (16) dans leurs positions de consigne respectives sur les parois de cage (18a, 18b, 18c, 18d).
